# EUROPÄISCHE PATENTSCHRIFT

(11) **EP 1 622 204 B1**
(45) Veröffentlichungstag und Bekanntmachung des Hinweises auf die Patenterteilung: **26.08.2009**
(21) Anmeldenummer: 04090301.5
(22) Anmeldetag: 28.07.2004
(51) Int. Cl.: H01L 31/0203, H01L 33/00, G02B 6/42

(54) **Verfahren zum Herstellen eines mit einem Kunststoffgehäuse versehenen optischen oder elektronischen Moduls**
Method of producing an optical or electronic module provided with a plastic casing
Méthode de fabrication d'un module optique ou électronique comportant un boîtier en plastique

(43) Veröffentlichungstag der Anmeldung: 01.02.2006
(73) Patentinhaber: Avago Technologies Fiber IP (Singapore) Pte. Ltd., Singapore 768923 (SG)
(72) Erfinder: Hurt, Hans, 93049 Regensburg (DE); Wittl, Josef, 92331 Parsberg (DE); Weberpals, Frank, 93047 Regensburg (DE); Schunk, Nikolaus, 93142 Maxhhütte-Haidhof (DE); Auburger, Albert, 93128 Regenstauf (DE); Paulus, Stefan, 93197 Zeitlarn (DE)
(74) Vertreter: Dilg, Haeusler, Schindelmann Patentanwaltsgesellschaft mbH

(56) Entgegenhaltungen:
- DE-A1- 10 117 890
- DE-A1- 10 144 467
- DE-A1- 10 150 986
- DE-A1- 10 151 113
- DE-A1- 19 810 060
- DE-A1- 19 909 242
- PATENT ABSTRACTS OF JAPAN Bd. 2003, Nr. 07, 3. Juli 2003 (2003-07-03) -& JP 2003 068939 A (MATSUSHITA ELECTRIC IND CO LTD), 7. März 2003 (2003-03-07)

## Beschreibung

Die Erfindung betrifft ein Verfahren zum Herstellen eines mit einem Kunststoffgehäuse versehenen optischen oder elektronischen Moduls, bei dem eine mit der Umgebung in Wirkverbindung stehende Komponente nach dem Umhüllen der Modulkomponenten mit einer Kunststoffmasse in einem sich daran anschließenden Verfahrensschritt teilweise wieder freigelegt wird.

Es ist bekannt, optoelektronische Module mit einem transparenten Vergussmaterial zu vergießen. So ist beispielsweise aus der DE 199 09 242 A1 ein opto-elektronisches Modul bekannt, bei dem ein Leadframe mit einem opto-elektronischen Wandler in einem Modulgehäuse positioniert und mit einem lichtdurchlässigen, formbaren Kunststoffmaterial vergossen wird. Eine Lichtein- oder Auskopplung erfolgt über eine Lichtleitfaser, die an einem Stutzen des Modulgehäuses angekoppelt wird. Auf dem Leadframe befindet sich auch der Treiberbaustein bzw. Empfangsbaustein für den opto-elektronischen Wandler.

Allerdings weist die Verwendung von Vergussmaterialien, die für den jeweiligen Wellenlängenbereich transparent sind, insofern Nachteile auf, als transparente Vergussmaterialien in der Regel einen hohen thermischen Ausdehnungskoeffizienten besitzen und dementsprechend bei großen Temperaturschwankungen Spannungen im Package auftreten, die insbesondere die empfindlichen Bonddraht-Verbindungen beschädigen können.

Es ist daher grundsätzlich vorteilhaft, für ein Vergießen oder Verpressen der Komponenten eines Moduls nichttransparente Kunststoffmaterialien einzusetzen, die mit Füllstoffen versehen sind, die einen günstigen thermischen Ausdehnungskoeffizienten des Kunststoffmaterials bereitstellen. Nachteilig bei der Verwendung solcher Kunststoffe als Vergussmaterial ist, dass innerhalb des Vergussmaterials kein optischer Pfad realisiert werden kann.

Ein weiteres Problem insbesondere bei der Verwendung einer nicht transparenten Vergussmasse besteht darin, dass nach dem Vergießen die exakte Lage der einzelnen Komponenten nicht mehr ohne weiteres erkennbar ist. Eine exakte Bestimmung der Lage beispielsweise eines optoelektronischen Wandlers in dem Modul kann jedoch wünschenswert sein.

Vergleichbare Probleme können sich auch bei rein elektronischen, mit einem Kunststoffgehäuse versehenen Modulen ergeben, sofern das Erfordernis besteht, eine Komponente des Moduls in Wirkverbindung mit der Umgebung zu bringen und hierzu deren Lage exakt zu bestimmen.

Das Dokument DE 101 44 467 A1 zeigt ein optisches Modul, wobei eine optische Komponente zuerst auf einem Auflagesockel auf einem Substrat aufgebracht wird. Der Sockel sorgt für die Bildung eines Hohlraumes, der den aktiven Bereich der Komponente von einer Kunststoffmasse bei der Umhüllung freiläßt. Beim Entfernen des Substrates bleibt der aktiven Bereich frei zugänglich.

Der vorliegenden Erfindung liegt dementsprechend die Aufgabe zu Grunde, ein Verfahren zum Herstellen eines mit einem Kunststoffgehäuse versehenen optischen oder elektronischen Moduls zur Verfügung zu stellen, das es in einfacher und äußerst präziser Art und Weise ermöglicht, eine vergossene Komponente des Moduls in Wirkverbindung mit der Umgebung zu bringen.

Diese Aufgabe wird erfindungsgemäß durch ein Verfahren mit den Merkmalen des Anspruchs 1 gelöst. Bevorzugte und vorteilhafte Ausgestaltungen der Erfindung sind in den Unteransprüchen angegeben.

Danach zeichnet sich die erfindungsgemäße Lösung dadurch aus, dass vor oder nach dem Umhüllen der optischen oder elektronischen Komponente die Position der Komponente durch direkte Messung erfasst wird. Die Komponente wird dann in Bezug auf eine Vorrichtung zum partiellen Entfernen der Kunststoffmasse ausgerichtet oder die Vorrichtung wird in Bezug auf die Komponente ausgerichtet, wobei das Ausrichten unter Berücksichtigung der direkt erfassten Position in der Komponente erfolgt. Nach dem Ausrichten kann die Kunststoffmasse partiell von außen durch die Vorrichtung mit hoher Präzision und in exakt einem freizulegenden Bereich entfernt werden, wobei die Kunststoffmasse zwischen dem Wirkbereich der Komponente und der Außenseite des Kunststoffgehäuses zumindest teilweise entfernt wird. Es ist also vorgesehen, die fragliche Komponente nach dem Umhüllen mit einem Kunststoffmaterial wieder freizulegen, d.h. das sie abdeckende Kunststoffmaterial wieder zu entfernen, damit sie in Wirkverbindung mit der Umgebung treten kann, und zuvor die exakte Position der Komponente durch direkte Messung zu bestimmen.

Die erfindungsgemäße Lösung sieht dabei nicht vor, die Position der freizulegenden Komponente lediglich indirekt zu erfassen, beispielsweise durch vorherige Bestimmung der relativen Position zwischen der Komponente und einer Referenzgeometrie, beispielsweise der Außengeometrie des Kunststoffgehäuses oder der Außengeometrie eines Trägers, auf dem die freizulegende Komponente montiert ist. Vielmehr wird die Position der freizulegenden Komponente durch direkte Messung erfasst. Durch die direkte exakte Erfassung der Lage der freizulegenden Komponente kann das Modul dann exakt an der gewünschten Position geöffnet werden. Toleranzen, die beim Bestücken eines Trägers mit der Komponente und bei der Herstellung des Moduls auftreten und die in eine indirekte Positionsbestimmung einfließen würden, werden hierdurch eliminiert. Die Erfindung beruht somit auf dem Gedanken, vor dem Öffnen des vergossenen Moduls die Lage bzw. Position der integrierten Komponente direkt zu bestimmen und die direkt bestimmte Position dann als Referenz beim partiellen Öffnen des Kunststoffgehäuses zu verwenden.

Es wird darauf hingewiesen, dass ein Umhüllen des Moduls nicht notwendigerweise mit nur einer Kunststoffmasse erfolgt. Es können auch mehrere Kunststoffmassen, die eventuell eine unterschiedliche Transparenz aufweisen, verwendet werden. Beispielsweise kann vorgesehen sein, dass die freizulegende Komponente zunächst mit einer transparenten Kunststoffmasse umhüllt wird. Anschließend erfolgt ein Umhüllen mit einer nichttransparenten Kunststoffmasse. Bei einem sich daran anschließenden partiellen Entfernen der Kunststoffmasse ist es dann ausreichend, dass die nichttransparente Kunststoffmasse entfernt wird. Dementsprechend ist es je nach Ausgestaltung ausreichend, dass die Kunststoffmasse zwischen dem Wirkbereich der Komponente und der Außenseite des Kunststoffgehäuses nicht vollständig, sondern eventuell nur teilweise entfernt wird. Sofern ausschließlich eine nichttransparente Kunststoffmasse zum Umhüllen verwendet wird, wird der Wirkbereich der Komponente jedoch vollständig freigelegt.

Unter einem Wirkbereich der optischen oder elektrischen Komponente wird jeder Bereich bezeichnet, der eine Wirkverbindung der Komponente mit der Umgebung ermöglicht. Beispielsweise handelt es sich um den photosensitiven Bereich einer Photodiode, um den Sensorbereich eines Drucksensors oder eines Temperatursensors, um den lichtemittierenden Bereich eines Halbleiterlasers oder einer LED oder um die der Modul-Außenseite zugewandte Fläche einer Linse, eines Spiegels oder eines Prismas.

Eine direkte Messung der Position der Komponente bedeutet, dass deren Lage (d.h. deren Koordinaten im einem 3-dimensionalen Koordinatensystem) in Bezug auf ein außerhalb des Moduls liegendes externes Koordinatensystem durch Messung direkt erfasst wird. In diesem externen Koordinatensystem wird auch die Vorrichtung zum partiellen Entfernen der Kunststoffmasse ausgerichtet und positioniert. Bei einer indirekten Messung der Position würde dagegen das mit Toleranzen behaftete Modul selbst das Koordinaten- und Referenzsystem für die Positionsbestimmung der Komponente darstellen.

Die Vorrichtung zum partiellen Entfernen der Kunststoffmasse wird unter Berücksichtigung der direkt erfassten Position der Komponente in dem externen Koordinatensystem auf die Komponente ausgerichtet oder umgekehrt. Eine Öffnung im Modul, die beim partiellen Entfernen der Kunststoffmasse entsteht, weist eine minimale Toleranz auf: der Abstand (Offset) zwischen der Achse der freizulegenden Komponente und der Achse der Modulöffnung ist minimal.

In einer bevorzugten Ausgestaltung der Erfindung erfolgt eine direkte Messung der Position der Komponente noch vor einem Umhüllen mit der mindestens einen Kunststoffmasse. Die Messung erfolgt dabei bevorzugt mittels eines Bilderkennungssystems, beispielsweise unter Verwendung eines Kamerasystems und eines zugeordneten Computers. Die so erhaltenen Informationen über die Lage der Komponente dienen dabei als Referenz, wenn nach dem Umhüllen der Komponente diese partiell wieder freigelegt wird. Es ist bei dieser Ausgestaltung dabei bevorzugt vorgesehen, dass die Lage der Komponente sich nach der Positionserfassung nicht mehr ändert.

In einer weiteren bevorzugten Ausgestaltung ist die verwendete Kunststoffmasse transparent und wird zur direkten Messung der Position der Komponente deren Lage nach dem Vergießen ebenfalls mittels eines Bilderkennungssystem erfasst. Der Einsatz eines Bilderkennungssystems erfolgt dabei wie zuvor beschrieben. Es ist hierbei möglich, ein Bilderkennungssystem zur direkten Messung der Position der fraglichen Komponente zu verwenden, da die Kunststoffmasse transparent ist.

In einer weiteren bevorzugten Ausgestaltung ist mindestens eine Kunststoffmasse nicht transparent und erfolgt eine direkte Messung der Position der Komponente erst nach dem Vergießen. Zur direkten Messung der Position der Komponente wird dabei bevorzugt eine Ultraschall-Messvorrichtung oder eine Röntgenstrahl-Messvorrichtung eingesetzt, über die die Position der freizulegenden Komponente in Bezug auf ein Koordinatensystem erfasst wird, in dem auch die Vorrichtung zum partiellen Entfernen der Kunststoffmasse ausgerichtet wird.

In einer bevorzugten Ausgestaltung wird die optische oder elektronische Komponente vor dem Umhüllen mit Kunststoff durch elektrische Verbindungen, insbesondere mittels Bonddrähten elektrisch kontaktiert. Dabei liegen die elektrischen Verbindungen bevorzugt in einem Bereich der Kunststoffmasse, in dem ein partielles Entfernen der Kunststoffmasse nicht erfolgt. Die Bonddrähte können daher bei dem Freilegen der Komponente nicht beschädigt werden.

Die optische oder elektronische Komponente wird bevorzugt vor dem Umhüllen auf einem Träger angeordnet. Der Träger des Moduls ist bevorzugt als Leadframe, auch als Metallträger oder Stanzgitter bezeichnet, ausgebildet. Das Leadframe weist dabei bevorzugt mindestens einen planen Trägerbereich, auch als "die pad" oder "Chipinsel" bezeichnet, sowie eine Mehrzahl von Kontaktbeinen auf, die sich am Randbereich des Leadframes befinden. Die optische oder elektronische Komponente wird dabei jeweils auf einem Trägerbereich angeordnet. Grundsätzlich können statt eines Leadframes aber auch beliebige andere Träger eingesetzt werden, beispielsweise Träger, die aus einer strukturierten Kunststofffolie bestehen oder aus einer Leiterplatte. Auch kann auf einen gesonderten Träger grundsätzlich ganz verzichtet werden.

Die optische Komponente ist bevorzugt ein opto-elektronisches Sendebauelement oder ein opto-elektronisches Empfangsbauelement, insbesondere eine Photodiode oder eine LED oder ein Halbleiterlaser. Jedoch kann es sich bei dem optischen Bauelement beispielsweise auch um eine Linse, einen optischen Filter, ein Prisma, einen Spiegel oder dergleichen handeln. Sofern es sich bei der Komponente um eine elektronische Komponente handelt, ist diese bevorzugt ein Sensor, insbesondere ein Drucksensor oder ein Temperatursensor.

Zum partiellen Entfernen der Kunststoffmasse wird beispielsweise eine Fräsvorrichtung oder eine Laser-Abtragvorrichtung verwendet. Dabei spielt der konkrete Aufbau der Vorrichtung keine Rolle. Die Vorrichtung muss lediglich ein definiertes partielles Abtragen des Kunststoffmaterial ermöglichen.

Der Schritt des Umhüllens mit Kunststoffmasse umfasst bevorzugt ein Vergießen oder Verpressen der Komponente mit der Kunststoffmasse. Das Vergießen oder Verpressen kann dabei in einem speziellen Werkzeug, insbesondere einem Spritzgusswerkzeug erfolgen.

Die Erfindung wird nachfolgend unter Bezugnahme auf die Figuren anhand eines Ausführungsbeispieles näher erläutert.
Es zeigen:

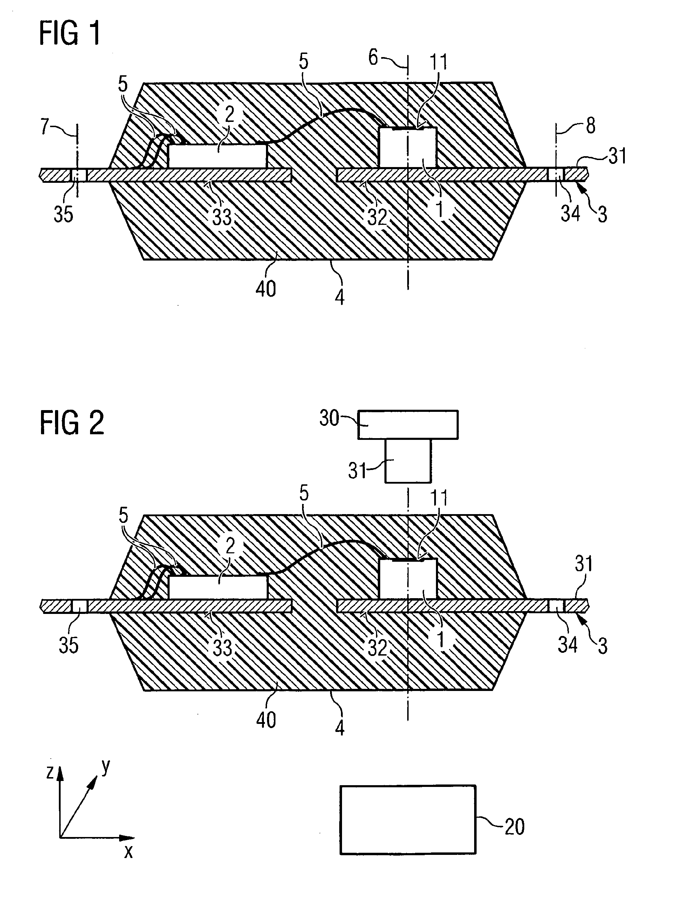

- Figur 1: eine Schnittansicht eines optischen Moduls mit einer optischen Komponente während der Herstellung des Moduls und nach Vergießen des Moduls mit einer Kunststoffmasse;
- Figur 1,: das optische Modul gemäß der Figur 2, sowie Mittel zum Messen der Position der optischen Komponente und Mittel zum partiellen Entfernen der Kunststoffmasse;
- Figur 3: das fertige optische Modul, hergestellt nach dem Verfahren der vorliegenden Erfindung; und
- Figur 4: das fertige optische Modul, hergestellt nach einem alternativen Verfahren.

Die Figur 1 zeigt ein optisches Modul mit einer optischen Komponente 1 und einem zugeordneten elektronischen Baustein 2, die auf einem Leadframe 3 angeordnet und mit einer nicht transparenten Kunststoffmasse 40, die ein Kunststoffgehäuse 4 bereitstellt, vergossen sind.

Bei der optischen Komponente 1 handelt es sich beispielsweise um eine Lumineszenzdiode (LED), einen Halbleiterlaser oder eine Photodiode. Bei dem elektronischen Baustein 2 handelt es sich beispielsweise um einen Treiber oder einen Vorverstärker. Die optische Komponente 2 ist bevorzugt als vorgefertigter Chip ausgebildet. Der elektronische Baustein 2 ist bevorzugt als integrierter Schaltkreis (IC) ausgebildet.

Der Leadframe 3 weist zwei plane Trägerflächen 32, 33 auf, die auch als "die pad" bezeichnet werden und auf denen zum einen die optische Komponente 1 und zum anderen der elektronische Baustein 2 angeordnet sind. Des weiteren besitzt der Leadframe 3 an seinem Rand eine Mehrzahl von Kontaktbeinen (leads). Die Kontaktbeine stehen dabei aus der Vergussmasse 4 hervor. Derartige Leadframes 3 sind im Stand der Technik bekannt, so dass hierauf nicht weiter eingegangen wird.

Auf den beiden Trägerflächen 32, 33 sind die optische Komponente 1 und der elektronische Baustein 2 angeordnet. Eine elektrische Kontaktierung dieser Modulkomponenten 1, 2 erfolgt zum einen durch einen Kontakt auf der Unterseite, der direkt mit der jeweiligen Trägerfläche 32, 33 elektrisch verbunden ist, sowie zum anderen über Bonddrähte 5.

Die optische Komponente 1 weist an ihrer Oberseite eine Wirkfläche 11 auf. Beispielsweise handelt es sich um eine lichtemittierende Fläche 11 eines LED-Chips.

Die Kunststoffmasse 40 ist zur Bereitstellung eines günstigen thermischen Ausdehnungskoeffizienten mit einem Füllstoff versehen und daher nicht transparent für das emittierte oder empfangene Licht. Der optische Pfad des optischen Bauelements 1 ist verschlossen.

Es ist daher vorgesehen, in einem weiteren Verfahrensschritt eine Öffnung 9 in die Kunststoffmasse 40 einzubringen, so dass die Wirkfläche 11 der optischen Komponente 1 freigelegt und die optische Komponente 1 in Wirkverbindung mit der Umgebung treten kann.

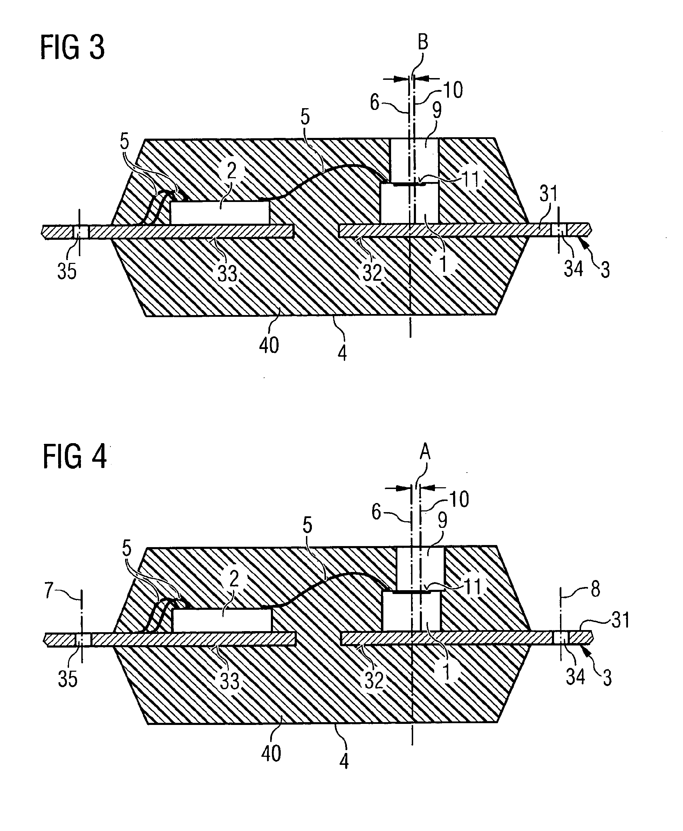

Es wird hierzu zunächst ein Verfahren unter Bezugnahme auf die Figur 4 beschrieben und erläutert, das nicht dem erfindungsgemäßen Verfahren entspricht. Dabei wird die Position der optische Komponente 1 indirekt relativ zu einer Referenzgeometrie des Moduls bestimmt. Eine solche Referenzgeometrie kann beispielsweise durch Referenzbohrungen 34, 35 am Leadframe 3 bereitgestellt werden, wodurch Referenzachsen 7, 8 definiert werden. Sofern man die relative Lage der optische Komponente 1 in Bezug auf diese Referenzachsen 7, 8 kennt, kann man dann indirekt auf die Position der optische Komponente 1 schließen.

Die Figur 4 zeigt das Modul der Figur 1, nachdem über eine solche indirekte Erfassung der Position der optischen Komponente 1 eine Aussparung 9 in der Kunststoffmasse 40 eingebracht wurde. Eine solche Aussparung 9 kann beispielsweise über eine Fräsvorrichtung oder über eine Laser-Abtragvorrichtung bereitgestellt werden. Der Nachteil bei diesem Verfahren besteht jedoch darin, dass eine große Tolerenzkette bei der Bestimmung der Position der optischen Komponente auf dem Leadframe 3 vorliegt. So addieren sich Toleranzen hinsichtlich der Lage der optische Komponente 1 auf dem Leadframe 1 und hinsichtlich der Anordnung der Referenzbohrungen 34, 35 in dem Leadframe 3. Sofern alternativ als Referenz für die Bestimmung der Lage der optische Komponente 1 die Außenabmessung des Kunststoffgehäuses 4 dienen würde, so würde neben der Ablagetoleranz der optischen Komponente 1 auf dem Leadframe 3 die Toleranz hinsichtlich der Außenmaße des Gehäuses 12 zur Toleranzkette beitragen.

Die indirekte Erkennung der Lage der freizulegenden Komponente 1 ist somit notwendigerweise verbunden mit einer sehr langen Toleranzkette. Dies kann dazu führen, dass ein relativ großer Abstand A (Offset) zwischen der Achse 6 der freizulegenden Komponente 1 und der Achse 10' der freigelegten Öffnung 9 im Kunststoffgehäuse 4 existiert.
Dies ist in der Figur 4, die zusätzlich die Öffnung 9 zeigt, zur besseren Anschaulichkeit etwas übertrieben dargestellt. Die nicht exakte Ausbildung der Öffnung 9 im Kunststoffgehäuse 4 kann nachteilig beispielsweise dazu führen, dass die optische aktive Fläche 11 nur teilweise zur Lichtabstrahlung oder zur Lichtdetektion bereitsteht. Auch kann eine nicht exakte Ausrichtung der Öffnung zu Problemen bei der Ankopplung weiterer Komponenten an das Modul führen.

Es ist daher vorgesehen, die Position der optischen Komponente 1 durch direkte Messung zu erfassen. Dies ist in der Figur 2 schematisch dargestellt. Eine schematisch dargestellte Messvorrichtung 20 erfasst die exakte Position der optischen Komponente 1 in Bezug auf ein Koordinatensystem. Die Positionserfassung erfolgt beispielsweise über eine Ultraschall-Messvorrichtung 20 oder eine Röntgenstrahl-Messvorrichtung 20. Bei einem transparenten Vergussmaterial oder bei Erfassen der Position der optischen Komponente 1 noch vor dem Vergießen kann auch eine Bilderkennung bzw. ein Kamerasystem zur Positionsbestimmung eingesetzt werden. Die ermittelte Position dient nun als Referenz für die Ausrichtung einer Vorrichtung 30 zum partiellen Entfernen des Kunststoffmaterials. Diese Vorrichtung ist in der Figur 2 lediglich beispielhaft schematisch als Fräsvorrichtung 30 mit einem Fräskopf 31 dargestellt.

Die Vorrichtung 30 wird nun in Bezug auf die optische Komponente 1 ausgerichtet, oder die optische Komponente 1 auf die Vorrichtung 30. Dies hängt davon ab, ob die optische Komponente 1 und das Modul oder die Vorrichtung 30 verschiebbar bzw. einfacher verschiebbar sind. Das Ausrichten erfolgt unter Berücksichtigung der direkt erfassten Position der optischen Komponente 1. Die Position der Vorrichtung 3 wird dabei durch dasselbe Koordinatensystem festgelegt, relativ zu dem auch die Position der optischen Komponente 1 direkt gemessen wurde.

Das auf diese Weise mit einer Öffnung 9 versehene Modul zeigt die Figur 3. Es ist dabei ersichtlich, dass der Offset B zwischen der optischen Achse 9 der optischen Komponente 1 und der Symmetrieachse 10 der Öffnung 9 wesentlich geringer ist als bei dem Verfahren gemäß der Figur 4.

Bei der direkten Messung wird die Position der optischen Komponente 1 direkt bestimmt und wird nicht lediglich indirekt über eine Referenzgeometrie auf die Position der optischen Komponente zurückgeschlossen. Die Gehäuseöffnung 9 kann auf diese Weise mit minimalen Toleranzen bereitgestellt werden.

Es wird darauf hingewiesen, dass die Komponente 1 auch eine elekronische Komponente sein kann. Es kann es sich bei der Komponente 1 beispielsweise um einen Sensor-Chip handeln, insbesondere um einen Drucksensor oder einen Temperatursensor, wie sie in der Automobilindustrie Anwendung findet.

Des Weiteren wird darauf hingewiesen, dass das Modul mehrere optische oder elektronische Komponenten der beschriebenen Art aufweisen kann, wobei dann für jede der Komponenten eine direkte Messung der Position und ein exaktes partielles Entfernen der Kunststoffmasse unter Bereitstellung jeweils einer Öffnung im Gehäuse erfolgt.

Schließlich wird auch darauf hingewiesen, dass die Herstellung des optischen oder elektronischen Moduls bevorzugt im Nutzen auf einem Multinest-Werkzeug erfolgt, wobei nach Aushärten des Kunststoffmaterials sowie nach Freilegen der jeweiligen Komponenten die einzelnen optischen oder elektronischen Module vereinzelt werden.

## Patentansprüche

1. Verfahren zum Herstellen eines mit einem Kunststoffgehäuse versehenen optischen oder elektronischen Moduls, mit folgenden Schritten:
- Bereitstellen mindestens einer optischen oder elektronischen Komponente (1), wobei die Komponente (1) einen Wirkbereich (11) aufweist, über den sie im fertigen Modul in Wirkverbindung mit der Umgebung steht,
- Anordnen der optischen oder elektronischen Komponente (1) auf einem Träger (3),
- elektrisches Kontaktieren der optischen oder elektronischen Komponente (1) durch elektrische Verbindungen (5),
- Umhüllen der mindestens einen Komponente (1) mit mindestens einer Kunststoffmasse (40) zur Ausbildung des Kunststoffgehäuses (4), wobei das Anordnen und das elektrische Kontaktieren vor dem Umhüllen durchgeführt wird,
- vor oder nach dem Umhüllen Erfassen der Position der Komponente (1) durch direkte Messung der Position der Komponente (1),
- Ausrichten der Komponente (1) in Bezug auf eine Vorrichtung (30) zum partiellen Entfernen der Kunststoffmasse oder Ausrichten einer solchen Vorrichtung (30) in Bezug auf die Komponente (1), wobei das Ausrichten unter Berücksichtigung der direkt erfassten Position der Komponente (1) erfolgt,
- partielles Entfernen der Kunststoffmasse (40) von außen durch die Vorrichtung (30) derart, dass die Kunststoffmasse (40) zwischen dem Wirkbereich (11) der Komponente (1) und der Außenseite des Kunststoffgehäuses (4) zumindest teilweise entfernt wird, so dass der Wirkbereich (11) freigelegt wird.

2. Verfahren nach Anspruch 1, **dadurch gekennzeichnet, dass** zur direkten Messung der Position der Komponente (1) deren Lage vor dem Umhüllen mit mindestens einer Kunststoffmasse (40) mittels eines Bilderkennungssystems erfasst und die so erhaltene Information über die Lage der Komponente beim partiellen Entfernen der Kunststoffmasse berücksichtigt wird.

3. Verfahren nach Anspruch 1, **dadurch gekennzeichnet, dass** die mindestens eine Kunststoffmasse (40) transparent ist und zur direkten Messung der Position der Komponente (1) deren Lage nach dem Umhüllen mittels eines Bilderkennungssystems erfasst und die so erhaltene Information über die Lage der Komponente beim partiellen Entfernen der Kunststoffmasse berücksichtigt wird.

4. Verfahren nach Anspruch 1, **dadurch gekennzeichnet, dass** mindestens eine Kunststoffmasse (40) nichttransparent ist und die direkte Messung der Position der Komponente (1) nach dem Umhüllen erfolgt.

5. Verfahren nach Anspruch 4, **dadurch gekennzeichnet, dass** zur direkten Messung der Position der Komponente (1) deren Lage nach dem Umhüllen mittels einer Ultraschall-Messvorrichtung (20) erfasst wird.

6. Verfahren nach Anspruch 4, **dadurch gekennzeichnet, dass** zur direkten Messung der Position der Komponente (1) deren Lage nach dem Umhüllen mittels einer Röntgenstrahl-Messvorrichtung (20) erfasst wird.

7. Verfahren nach mindestens einem der vorangehenden Ansprüche, **dadurch gekennzeichnet, dass** die elektrischen Verbindungen (5) in einem Bereich der Kunststoffmasse (40) liegen, in dem ein partielles Entfernen der Kunststoffmasse (40) nicht erfolgt.

8. Verfahren nach Anspruch 7, **dadurch gekennzeichnet, dass** die elektrischen Verbindungen zumindest teilweise durch Bonddrähte (5) bereitgestellt werden.

9. Verfahren nach mindestens einem der vorangehenden Ansprüche, **dadurch gekennzeichnet, dass** der Träger als Leadframe (3) ausgebildet ist, der zum einen mindestens einen planen Trägerbereich (32) und zum anderen eine Mehrzahl von Kontaktbeinen (31) aufweist, die sich am Randbereich des Leadframes befinden, und wobei die optische oder elektronische Komponente (1) jeweils auf einem Trägerbereich (32) angeordnet wird.

10. Verfahren nach mindestens einem der vorangehenden Anspruche, **dadurch gekennzeichnet, dass** die optische Komponente (1) ein opto-elektronisches Sendebauelement oder ein opto-elektronisches Empfangsbauelement ist.

11. Verfahren nach mindestens einem der vorangehenden Ansprüche, **dadurch gekennzeichnet, dass** die elektronische Komponente ein Sensor, insbesondere ein Drucksensor oder ein Temperatursensor ist.

12. Verfahren nach mindestens einem vorangehenden Ansprüche, **dadurch gekennzeichnet, dass** zum partiellen Entfernen der Kunststoffmasse (40) eine Fräsvorrichtung verwendet wird.

13. Verfahren nach mindestens einem der vorangehenden Ansprüche, **dadurch gekennzeichnet, dass** zum partiellen Entfernen der Kunststoffmasse (40) eine Laser-Abtragvorrichtung verwendet wird.

14. Verfahren nach mindestens einem der vorangehenden Ansprüche, **dadurch gekennzeichnet, dass** der Schritt des Umhüllens ein Vergießen oder Verpressen der mindestens einen Komponente (1) mit dem mindestens einen Kunststoffmaterial umfasst.

15. Verfahren nach mindestens einem der vorangehenden Ansprüche, **dadurch gekennzeichnet, dass** eine durch die Vorrichtung (30) zum partiellen Entfernen der Kunststoffmasse in das Kunststoffgehäuse (4) eingebrachte Öffnung (9) eine Symmetrieachse (10) aufweist, die mit der Achse der Komponente (1) im wesentlichen übereinstimmt.

## Claims

1. Method of manufacturing an optical or electronic module provided with a plastic casing, comprising the following steps:
- providing of at least one optical or electronic component (1), wherein the component (1) comprises an operative region (11), by which it is connected with the environment in operative connection in the completed module,
- arranging the optical or electronic component (1) on a carrier (3),
- contacting the optical or electronic component (1) electrically by electric connections (5),
- casing the at least one component (1) with at least one plastic compound (40) for forming the plastic casing (4), wherein the arranging and the electrically contacting is performed before the casing,
- before or after the casing, capturing the position of the component (1) by directly measuring the position of the component (1),
- aligning the component (1) in relation to a device (30) for partially removing the plastic compound or aligning such a device (30) in relation to the component (1), wherein the aligning takes place in consideration of the directly captured position of the component (1),
- partially eliminating the plastic compound (40) from the outside through the device (30) such that the plastic compound (40) between the operative region (11) of the component (1) and the outside of the plastic casing (4) is at least partially eliminated so that the operative region (11) is exposed.

2. Method according to claim 1, **characterized in that** for directly measuring the position of the component (1) the position of the component is captured before the casing with at least one plastic compound (40) by an image recognition system and the information about the location of the component obtained by this is considered when partially eliminating the plastic compound.

3. Method according to claim 1, **characterized in that** the at least one plastic compound (40) is transparent and, for directly measuring the position of the component (1), the location of the component is captured after the casing by an image recognition system and the information about the location of the component obtained by this is considered during the partially eliminating of the plastic compound.

4. Method according to claim 1, **characterized in that** at least one plastic compound (40) is non-transparent and the directly measuring of the position of the component (1) takes place after the casing.

5. Method according to claim 4, **characterized in that** for directly measuring the position of the component (1) the location of the component is captured after the casing by an ultrasonic measurement device (20).

6. Method according to claim 4, **characterized in that** for directly measuring the position of component (1) the location of the component is captured after the casing by an X-ray measurement device (20).

7. Method according to at least one of the preceding claims, **characterized in that** the electrical connections (5) are located in the region of the plastic compound (40), in which a partially eliminating of the plastic compound (40) does not take place.

8. Method according to claim 7, **characterized in that** the electrical connections are provided at least partially by bonding wires (5).

9. Method according to at least one of the preceding claims, **characterized in that that** the carrier is formed as a lead frame (3), which comprises on the one hand at least one planar carrier region (32) and on the other hand a plurality of contact legs (31), which are located at the periphery of the lead frame, and wherein the optical or electronic component (1) is arranged on a carrier region (32), respectively.

10. Method according to at least one of the preceding claims, **characterized in that** the optical component (1) is an optoelectronic transmitting component or an optoelectronic receiving component.

11. Method according to at least one of the preceding claims, **characterized in that** the electronic component is a sensor, in particular a pressure sensor or a temperature sensor.

12. Method according to at least one of the preceding claims, **characterized in that** a cutting device is used for partially eliminating the plastic compound (40).

13. Method according to at least one of the preceding claims, **characterized in that** a laser removing device is used for partially eliminating the plastic compound (40).

14. Method according to at least one of the preceding claims, **characterized in that** the step of casing comprises a moulding or grouting of at least one component (1) with the at least one plastic compound.

15. Method according to at least one of the preceding claims, **characterized in that** an opening (9) brought in by the device (30) for partially eliminating of the plastic compound into the plastic casing (4) comprises an axis of symmetry, which corresponds substantially with the access of the component (1).

## Revendications

1. Procédé pour fabriquer un module optique ou électronique pourvu d'un boîtier en plastique, avec les étapes suivantes :
- préparation d'au moins un composant optique ou électronique (1), le composant (1) présentant une zone active (11) via laquelle il est en connexion active avec les environs dans le module fini,
- agencement du composant optique ou électronique (1) sur un support (3),
- mis en contact électrique du composant optique ou électronique (1) via des connexions électriques (5),
- enrobage de l'au moins un composant (1) avec au moins une matière plastique (40) pour former un boîtier (4) en plastique, l'agencement et la mise en contact électrique intervenant avant l'enrobage,
- détection, avant ou après l'enrobage, de la position du composant (1) par mesure directe de la position du composant (1),
- orientation du composant (1) par rapport à un dispositif (30) pour enlever partiellement la matière plastique ou orientation d'un tel dispositif (30) par rapport au composant (1), l'orientation intervenant en tenant compte de la position directement détectée du composant (1),
- enlèvement partiel de la matière plastique (40) depuis l'extérieur par le dispositif (30), de sorte que la matière plastique (40) entre la zone active (11) du composant (1) et la face externe du boîtier (4) en plastique soit au moins en partie enlevée pour que la zone active (11) soit dégagée.

2. Procédé selon la revendication 1, **caractérisé en ce que** pour mesurer directement la position du composant (1), son emplacement est détecté avant l'enrobage avec au moins une matière plastique (40) au moyen d'un système de reconnaissance vidéo et l'information ainsi obtenue sur l'emplacement du composant est prise en compte lors de l'enlèvement partiel de la matière plastique.

3. Procédé selon la revendication 1, **caractérisé en ce que** l'au moins une matière plastique (40) est transparente et **en ce que** pour mesurer directement la position du composant (1), son emplacement est détecté après l'enrobage au moyen d'un système de reconnaissance vidéo et l'information ainsi obtenue sur l'emplacement du composant est prise en compte lors de l'enlèvement partiel de la matière plastique.

4. Procédé selon la revendication 1, **caractérisé en ce qu'**au moins une matière plastique (40) n'est pas transparente et **en ce que** la mesure directe de la position du composant (1) intervient après l'enrobage.

5. Procédé selon la revendication 4, **caractérisé en ce que** pour mesurer directement la position du composant (1), son emplacement est détecté après l'enrobage au moyen d'un dispositif (20) de mesure par ultrasons.

6. Procédé selon la revendication 4, **caractérisé en ce que** pour mesurer directement la position du composant (1), son emplacement est détecté après l'enrobage au moyen d'un dispositif (20) de mesure par rayons X.

7. Procédé selon au moins l'une des revendications précédentes, **caractérisé en ce que** les connexions électriques (5) se situent dans une zone de la matière plastique (40) dans laquelle un enlèvement partiel de la matière plastique (40) n'intervient pas.

8. Procédé selon la revendication 7, **caractérisé en ce que** les connexions électriques sont obtenues au moins en partie par des fils (5) de liaison.

9. Procédé selon au moins l'une des revendications précédentes, **caractérisé en ce que** le support est constitué en tant que bâti conducteur (3) présentant d'une part une zone (32) de support plane et d'autre part une pluralité de pattes de contact (31) situées dans la zone marginale du bâti conducteur, et **en ce que** le composant optique ou électrique (1) est chaque fois agencé sur une zone (32) de support.

10. Procédé selon au moins l'une des revendications précédentes, **caractérisé en ce que** le composant optique (1) est un élément émetteur optoélectronique ou un élément récepteur optoélectronique.

11. Procédé selon au moins l'une des revendications précédentes, **caractérisé en ce que** le composant électronique est un détecteur, en particulier un détecteur de pression ou un détecteur de température.

12. Procédé selon au moins l'une des revendications précédentes, **caractérisé en ce qu'**un dispositif de fraisage est utilisé pour enlever partiellement la matière plastique (40).

13. Procédé selon au moins l'une des revendications précédentes, **caractérisé en ce qu'**un dispositif d'enlèvement par laser est utilisé pour enlever partiellement la matière plastique (40).

14. Procédé selon au moins l'une des revendications précédentes, **caractérisé en ce que** l'étape d'enrobage comprend un encapsulage ou un pressage de l'au moins un composant (1) avec l'au moins un matériau plastique.

15. Procédé selon au moins l'une des revendications précédentes, **caractérisé en ce qu'**une ouverture (9) pratiquée par le dispositif (30) dans le boîtier (4) en plastique pour enlever partiellement la matière plastique présente un axe (10) de symétrie qui coïncide pour l'essentiel avec l'axe du composant (1).
